# FASCICULE DE BREVET EUROPEEN

(11) **EP 0 780 889 B1**
(45) Date de publication et mention de la délivrance du brevet: **20.11.2002**
(21) Numéro de dépôt: 96402754.4
(22) Date de dépôt: 17.12.1996
(51) Int. Cl.: H01L 21/285, H01L 21/768

(54) **Procédé de depôt sélectif d'un siliciure de métal réfractaire sur du silicium**
Verfahren zur selektiven Abscheidung von Siliciden hochschmelzender Metalle auf Silizium
Method of selective deposition of refractory metal silicide on silicon

(30) Priorité: 22.12.1995 FR 9515327
(43) Date de publication de la demande: 25.06.1997
(73) Titulaire: FRANCE TELECOM, 75015 Paris (FR)
(72) Inventeur: Regolini, Jorge, Cidex 38B 38190 Bernin (FR); Bensahel, Daniel, 38000 Grenoble (FR)
(74) Mandataire: Casalonga, Axel

(56) Documents cités:
- WO-A-95/15005
- DE-A- 4 238 080
- XING G C ET AL: "FORMATION OF SELF-ALIGNED TISI2 CONTACTS TO SI AT LOW TEMPERATURES USING TICL4 AND SIH4 WITH SELECTIVE IN-SITU PREDEPOSITION OF SIXGE1-X" 1 Octobre 1993 , MATERIALS LETTERS, VOL. 17, NR. 6, PAGE(S) 379 - 382 XP000413388 * page 379, colonne 2, alinéa 2 - page 380, colonne 2, alinéa 1 *
- MORITA M. ET AL: 'Growth of native oxide on a silicon surface' JOURNAL OF APPLIED PHYSICS vol. 68, no. 3, 01 Août 1990, WOODBURY, NY, US, pages 1272 - 1280

## Description

La présente invention concerne le domaine de fabrication des circuits intégrés à semiconducteurs silicium, et plus précisémment la métallisation de dispositifs semiconducteurs de silicium par dépôt d'un siliciure de métal réfractaire pour la réalisation de contacts et/ou d'interconnexions dans ces circuits intégrés.

De tels circuits intégrés comportent un certain nombre de composants électroniques réalisés dans la plaquette de silicium. Ces composants électroniques sont activés par prise de contacts métalliques sur les différentes zones actives desdits composants. Ces contacts sont reliés aux contacts des autres composants par des interconnexions afin d'assurer la fonctionnalité des circuits intégrés. Ainsi, par exemple, pour activer un transistor bipolaire, des contacts doivent être pris sur les zones de collecteur, de base et d'émetteur; et pour activer un transistor à effet de champ (MOS), des contacts doivent être pris sur les zones de source et de drain et sur la grille en silicium polycristallin.

Les contacts et interconnexions dans un circuit intégré peuvent être non seulement métalliques, mais encore en un siliciure de métal, notamment de métal réfractaire.

Les zones sur lesquelles ces contacts et interconnexions doivent être réalisés, sont soumises à une métallisation. Les zones de silicium à métalliser sont appelées zones de silicium apparent par opposition aux autres zones de silicium de la plaquette, recouvertes par un isolant, notamment par de l'oxyde de silicium. La métallisation des zones de silicium apparent peut être effectuée par différentes méthodes, telles que par dépôt d'un siliciure de métal réfractaire.

Bien que conservant un caractère général, l'invention sera décrite plus particulièrement en référence à la métallisation de dispositifs semiconducteurs silicium de circuits intégrés comportant des transistors à effet de champ (MOS) dans des technologies à règles de dessin inférieures à 0,5 µm, communément appellés technologies inférieures à 0,5 µm. Ces technologies correspondent plus précisémment à une longueur du canal séparant les zones de source et de drain du transistor inférieure à 0,5 µm. Ces transistors de très petite taille permettent la réalisation de circuits intégrés à haut niveau d'intégration de grand intérêt en microélectronique, tels que les circuits intégrés du type VLSI et ULSI.

Dans les technologies inférieures à 0,5 µm, les jonctions de source et de drain se situent à environ 0,1 µm sous la surface du silicium apparent. Pour assurer un bon fonctionnement de ces transistors, et donc du circuit intégré, ces jonctions peu profondes de source et de drain doivent être préservées lors de la prise de contacts.

Par ailleurs, une métallisation admissible des zones de silicium apparent pour les circuits intégrés à haut niveau d'intégration, doit générer un dépôt homogène dont la taille de grain des particules déposées est suffisamment petite pour que la surface de la couche déposée présente une rugosité très faible. Ces caractéristiques sont essentielles au bon fonctionnement de circuits intégrés fabriqués dans les technologies inférieures à 0,5 µm.

Différents procédés de l'art antérieur permettent le dépôt de siliciures de métaux réfractaires sur du silicium apparent.

Il est notamment connu du brevet américain US 4 619 038 de métalliser les régions de source et de drain, ainsi que la grille en silicium polycristallin d'un transistor a effet de champ, par un premier dépôt d'une couche de siliciure de titane, en plaçant la plaquette de silicium, partiellement masquée par de l'oxyde de silicium, dans une enceinte comprenant comme gaz réactif un halogénure de titane dilué dans de l'hydrogène. Il se forme ainsi une couche de siliciure de titane sur les régions de silicium apparent mono- et polycristallin à des températures comprises entre 700° et 1000°C.

On observe, lors de la mise en oeuvre de ce procédé, une importante consommation du silicium apparent qui comporte de lourdes conséquences puisque le siliciure de titane va pénétrer en profondeur dans les régions à métalliser. Ceci entraîne un risque important de perçage des jonctions, notamment des jonctions de source et de drain peu profondes qui se trouvent à environ 0,1 µm sous la surface du silicium apparent dans les technologies inférieures à 0,5 µm.

Cette méthode présente l'inconvénient supplémentaire d'un dépôt de rugosité importante. Ces imperfections du dépôt de siliciure de titane sont jugées inadmissibles notamment dans les technologies inférieures à 0,5 µm précédemment citées.

Un autre brevet américain US 4 501 769, décrit un procédé de dépôt sélectif d'un siliciure d'un métal réfractaire sur du silicium mono- et polycristallin mettant en oeuvre un mélange de gaz réactifs comprenant un gaz précurseur de silicium. Ce mélange de gaz réactifs a pour but d'éviter la consommation du silicium apparent du substrat sur lequel le dépôt sélectif a lieu.

Toutefois, un tel dépôt nécessite une température de réaction d'environ 850°C, température à laquelle, en présence du précurseur de métal réfractaire, la réaction avec le silicium apparent de la plaquette est inévitable. Le risque de perçage des jonctions ne peut donc être totalement écarté lorsque le procédé est appliqué à des transistors à effet de champ, notamment dans les technologies inférieures à 0,5 µm.

En outre, les couches de siliciure formées selon le procédé décrit dans le brevet US 4 501 769 présentent une grande taille de grain et donc une rugosité importante, caractéristique jugée inadmissible pour les applications visées, comme décrit précédemment.

La demande de brevet français 2 623 014 décrit une méthode de dépôt sélectif d'un siliciure de métal réfractaire proposant de pallier lesdits inconvénients que sont la rugosité importante et la consommation du silicium apparent.

Selon le procédé décrit, les plaquettes, lors d'une première étape dite de nettoyage, sont désoxydées. Cette étape de nettoyage consiste en un dépôt de siliciure de métal réfractaire sur-stoechiométrique en silicium en portant à une température comprise entre 800°C et 1000°C un mélange gazeux de silane, de tétrachlorure de titane, d'argon et d'hydrogène. Ce dépôt en sur-stoechiométrie de silicium vise la suppression de l'oxyde natif SiO₂ qui s'est formé sur les zones de silicium à métalliser. Dans une deuxième étape on effectue à une température plus basse, comprise entre 450°C et 700°C, un dépôt d'une couche de siliciure de métal réfractaire stoechiométrique en silicium en présence du même mélange gazeux mais à des pressions partielles différentes.

La première étape permet semble-t-il d'obtenir une rugosité moins importante de la surface de TiSi₂ déposé. Ce résultat peut s'interpréter par l'élimination de l'oxyde natif dont la présence perturberait le dépôt sélectif du siliciure de titane. En effet il semble que la sélectivité du dépôt et la présence d'oxyde natif favorise un dépôt par îlots démarrant en premier lieu dans les zones de nucléation exemptes d'oxyde natif. Un tel dépôt génère des couches à gros grain, d'importante rugosité.

La deuxième étape, l'étape de dépôt proprement dite, est effectuée dans le but de limiter la consommation du silicium apparent qui pourrait avoir lieu en présence du tétrachlorure de titane.

Les auteurs de la présente invention ont constaté que lors de la mise en oeuvre du procédé décrit dans la demande de brevet FR 2 623 014 une consommation du silicium apparent persiste. Donc, pour des applications dans les technologies citées précédemment le risque de perçage des jonctions peu profondes subsiste. De plus, la couche de siliciure de métal réfractaire formée comporte toujours des imperfections de surface, telles que des grains de trop grande taille et une rugosité trop importante pour une utilisation dans les technologies inférieures à 0,5 µm à haut niveau d'intégration.

En outre, les auteurs de la présente invention ont également mis en évidence que la couche de siliciure de titane obtenue par ce procédé, est formée de deux phases cristallographiques différentes du siliciure de titane dont l'une présente une résistivité beaucoup trop importante pour une application à la fabrication de circuits intégrés à haut niveau d'intégration. En effet, les circuits de type VLSI voient leurs performances considérablement limitées lorsque les niveaux de contacts et interconnexions présentent une résistivité trop grande.

La demande de brevet français n° 94 09819 décrit un procédé de dépôt sélectif en phase vapeur d'un siliciure d'un métal réfractaire sur le silicium mono- et polycristallin d'une plaquette de silicium comprenant les étapes suivantes :
(**i**) une étape de nettoyage destinée à préparer la surface de silicium au dépôt, en la rendant exempte non seulement de l'oxyde natif mais aussi de tous les autres résidus et impuretés présents à la surface du silicium;
(**ii**) une étape de dépôt d'une couche de silicium pour former un piédestal en silicium sur le silicium mono- et polycristallin propre de la plaquette; et
**(iii)** une étape de dépôt en phase vapeur d'un siliciure de métal réfractaire, consommant au moins: partiellement le piédestal de silicium formé lors de l'étape précédente.

Ce procédé permet de contrôler la consommation du silicium de la plaquette car il apparaît que le piédestal de silicium fourni par l'étape (ii) est au moins partiellement, voire totalement, consommé pour former la couche de siliciure du métal réfractaire; le silicium apparent de la plaquette est ainsi protégé par le piédestal lors du dépôt de l'étape (iii).

Par ailleurs, il apparaît que le dépôt ainsi obtenu sur une surface de silicium exempte d'oxyde natif et de tous types de résidus et impuretés, permet une croissance de grains de petite taille, conduisant à une couche homogène de faible rugosité compatible avec les technologies inférieures à 0,5 µm, telles qu'à haut niveau d'intégration.

Afin de débarrasser la surface de silicium à métalliser de l'oxyde natif et de tous les résidus et impuretés, provenant notamment des traitements technologiques que la plaquette a déjà pu subir, tels que la gravure ou l'implantation qui laissent notamment des résidus de carbone, on utilise des méthodes de nettoyage dont le choix dépend de ces traitements technologiques antérieurs. Des méthodes de nettoyage utilisables sont notamment des méthodes de nettoyage assistées par plasma ("soft - etch"), par oxyde sacrificiel (de 5 à 45 nm), par les deux méthodes consécutives, par traitement chimique tel que par un traitement du type RCA, par action de HF dilué ou par ces deux méthodes consécutives ou par toute autre méthode appropriée laissant la surface de silicium exempte de résidus, d'impuretés et d'oxyde natif.

Il peut arriver que lorsque les plaquettes ont subi certains traitements technologiques antérieurs, les surfaces de silicium ainsi nettoyées ne sont pas entièrement exemptes de résidus. Le dépôt de siliciure sur une telle surface pourrait avoir lieu par ilôts et former ainsi une couche rugueuse à gros grains.

La demande FR-A-94 09819 propose plus particulièrement de compléter cette première phase de nettoyage par une deuxième phase de préparation de surface appelée préparation "in situ", puisqu'elle pourra avoir lieu dans le même réacteur que l'étape (ii) de dépôt de la couche de silicium. Par opposition on appelle nettoyage "ex situ" la première phase de l'étape de nettoyage, décrite précédemment.

L'utilité fondamentale d'une telle préparation in situ est d'obtenir un dépôt répondant aux spécifications telles qu'une faible résistance d'accès et une continuité entre deux zones dopées n et p. On obtient ainsi une surface aussi parfaite que possible avant le dépôt épitaxial de Si, suivi du dépôt chimique en phase vapeur (CVD) de TiSi₂.

Bien que l'on ait obtenu des résultats satisfaisants avec la technique décrite dans la demande FR-94 09819, on a observé une tendance au perçage des jonctions, ou en termes de matériaux une croissance de TiSi₂ se propageant dans le substrat par consommation du Si du substrat, perçant ainsi les jonctions. Malgré la formation du piédestal de silicium et malgré l'apport de silicium par la phase gazeuse (SiH₄+TiCl₄), on observe une telle tendance au perçage des jonctions.

On a également étudié l'influence de la présence d'une couche d'oxyde d'épaisseur réglée pour la fabrication de certains dispositifs semi-conducteurs.

Ainsi, l'article intitulé "Application of a Cluster Tool for Interface Engineering of Polysilicon Emitters (Application d'un train de réacteur pour l'Ingéniérie d'interface d'Emetteurs Polysilicium)" R.H. REUSS,C. WERKHOVEN,E. GRANNEMAN,M. HENDRICKS, IEEE 1993 Bipolar Circuits and Technology Meeting 3.4, CH3315-9/93/0000(0049)$1.00 © 1993 IEEE décrit la réalisation d'une couche d'oxyde ultra-mince de haute qualité par un procédé d'oxydation à haute température avant le dépôt de polysilicium pour former l'émetteur d'un transistor bipolaire dans un train de réacteurs ("cluster tool").
Cet article mentionne qu'on obtient un gain en courant élevé mais que la résistance de l'émetteur est néfastement affectée.

L'Article "Formation of self-aligned TiSi₂ contacts to Si at low temperatures using TiCl₄ and SiH₄ with selective in-situ predeposition of SiₓGe₁₋ₓ (Formation de contacts TiSi₂ auto-alignés avec Si à basses températures utilisant TiCl₄ et SiH₄ avec un dépôt sélectif in situ de SiₓGe₁₋ₓ)", Materials letters, vol. 17, Nr. 6, pages 379-382, 1993, G.C. Xing et al, décrit un procédé de formation de TiSi₂ à des températures aussi basses que 625°C par prédépôt in-situ d'une couche sélective de SiₓGe₁₋ₓ.

On a également envisagé la formation d'une couche sub-nanométrique d'oxyde entre un dépôt de polysilicium et un substrat dopé dans un train de réacteurs ("cluster tool"). La présence de la couche d'oxyde sub-nanométrique permet de régler le gain en courant de transistors bipolaires à poly-émetteurs à vitesse élevée aux valeurs voulues tout en simultanément réduisant la résistance de contact du collecteur.

Enfin, on a suggéré l'obtention de couches sub-nanométriques d'oxyde de silicium par ozonisation et d'oxynitrure de silicium par traitement avec NO de plaquettes de silicium pour favoriser le dépôt ultérieur d'une couche de polysilicium.

La présente invention a pour objet de fournir un procédé de dépôt de siliciure de métal réfractaire sur une surface d'une plaquette en silicium mono- ou polycristallin dans lequel on empêche la croissance du siliciure de métal réfractaire par consommation du silicium du substrat, évitant ainsi un risque de perçage des jonctions.

Selon l'invention on atteint les objectifs ci-dessus par la mise en oeuvre d'un procédé de dépôt sélectif d'un siliciure de métal réfractaire sur une surface d'une plaquette en silicium mono- ou polycristallin caractérisé en ce qu'il comprend :
- une étape de préparation de ladite surface consistant à former sur cette surface une couche d'épaisseur e ≤1 nm d'oxyde de silicium ou d'oxynitrure de silicium; et
- une étape de dépôt chimique en phase vapeur (CVD), sélectif, sur la couche d'oxyde ou d'oxynitrure de silicium, d'un siliciure de métal réfractaire.

La couche d'oxyde de silicium ou d'oxynitrure de silicium de la présente invention, ci-après désignée par couche d'épaisseur sub-nanométrique, doit présenter des caractéristiques spécifiques pour la mise en oeuvre du procédé selon l'invention :
- elle doit bloquer la progression de la naissance du siliciure de métal réfractaire lors de l'étape de dépôt de ce siliciure et en particulier elle ne doit pas s'évaporer lors du dépôt du siliciure de métal réfractaire par CVD, par exemple sous l'action réductrice de l'hydrogène ou du SiH₄ utilisés dans cette étape;
- elle doit être reproductible;
- elle doit être suffisamment mince pour ne pas agir comme une surface épaisse d'oxyde, telle qu'une surface épaisse de SiO₂, auquel cas il n'y aurait pas de dépôt sélectif de siliciure de métal réfractaire.

Elle doit être également suffisamment mince pour assurer le contact ohmique entre le dépôt de siliciure de métal réfractaire et les zones sous-jacentes dopées de la plaquette de silicium.

On a trouvé, selon l'invention qu'une épaisseur e ≤1 nm pour cette couche d'oxyde ou d'oxynitrure de silicium permet d'obtenir les résultats recherchés. De préférence, la couche d'oxyde ou d'oxynitrure de silicium a une épaisseur comprise entre 0,1 et 1 nm, mieux encore une épaisseur de l'ordre de 0,5 à 0,9 nm. De préférence la couche d'oxyde de silicium sera une couche répondant à la formule SiOx dans laquelle x est ≤2. L'oxyde de silicium particulièrement recommandé selon l'invention est le dioxyde de silicium SiO₂.

La couche d'oxynitrure de silicium répond à la formule générale SiOxNy dans laquelle x est ≤3 et y est ≤4.

Avant de procéder à l'étape de dépôt de la couche sub-nanométrique d'oxyde ou d'oxynitrure de silicium on débarrasse la surface de la plaquette de silicium à traiter de l'oxyde natif et de tous les résidus et impuretés, provenant notamment des traitements technologiques que la plaquette a déjà pu subir, tels que la gravure ou l'implantation qui laissent notamment des résidus de carbone. On peut dans ce but utiliser des méthodes de nettoyage dont le choix dépend de ces traitements technologiques antérieurs. Des méthodes de nettoyage assistées par plasma ("soft-etch"), par oxyde sacrificiel (de 5 à 45 nm), par les deux méthodes consécutives, par traitement chimique tel que par un traitement du type RCA, par action de HF dilué ou par ces deux méthodes consécutives ou par toute autre méthode appropriée laissant la surface de silicium exempte de résidus, d'impuretés et d'oxyde natif.

Une méthode de nettoyage recommandée consiste à immerger la plaquette dans une solution aqueuse diluée d'acide fluorhydrique.

Le dépôt de la couche d'oxyde de silicium ou d'oxynitrure de silicium peut s'effectuer par tout procédé connu permettant d'obtenir une épaisseur réglée ≤1 nm de la couche.

En particulier, la couche d'oxyde de silicium sub-nanométrique peut être obtenue par oxydation sous recuit rapide, par passage dans un four à atmosphère oxydante, par exposition de la plaquette à une atmosphère oxydante contenant de l'ozone ou par immersion de la plaquette dans de l'eau contenant de l'ozone.

On recommande particulièrement l'exposition à une atmosphère contenant de l'ozone. Ce procédé consiste à exposer une plaquette en silicium préalablement nettoyée dans une solution aqueuse de HF à une atmosphère oxydante constituée d'un mélange de O₂ et O₃. L'exposition s'effectue sous pression atmosphérique ou réduite, de préférence 100 mbar, à une température de 20 à 400°C, de préférence 20 à 200°C, pendant un temps de quelques dizaines de secondes jusqu'à 10 minutes, de préférence 60 secondes. De préférence également le rapport en volume de la concentration en ozone à la concentration en oxygène est de 3%. Pour plus de détails quant à ce procédé on peut se référer à l'article "CONTROLLED THIN OXIDATION AND NITRIDATION IN A SINGLE WAFER CLUSTER TOOL" I. SAGNES et al, MRS 95 Spring Meeting, San Franscico.

Dans les conditions indiquées ci-dessus on obtient des couches d'oxyde de silicium (SiO₂) d'épaisseurs allant de 0,5 à 0,8 nm.

La formation d'une couche sub-nanométrique d'oxyde de silicium peut être réalisée dans une atmosphère contenant de l'oxygène (tel que l'air) au moyen d'un réacteur de type "cluster".

La croissance de la couche d'oxyde est déterminée par le choix de la teneur en oxygène de l'atmosphère, la pression, la température et la durée de l'oxydation. En mettant en oeuvre une telle étape d'oxydation au moyen d'un réacteur de type "cluster" on peut réaliser des couches d'oxydes de 0,2 à 1,0 nm

La couche d'oxynitrure de silicium (SiOxNy) de la présente invention peut être formée soit directement sur la surface nettoyée de la plaquette de silicium soit par nitruration d'une couche d'oxyde de silicium sub-nanométrique préalablement déposée sur la surface de la plaquette.

Le dépôt direct de la couche d'oxynitrure de silicium peut être effectué par mise en contact de la surface de la plaquette, avec une atmosphère contenant NH₃, N₂O, NO ou N₂O. On utilise de préférence une atmosphère contenant NO (en particulier du NO pur) car elle permet l'utilisation de températures relativement plus basses.

La nitruration des couches d'oxydes préalablement formées peut s'effectuer par mise en contact de la couche d'oxyde de silicium formée avec une atmosphère contenant N₂O ou NO. On recommande une atmosphère contenant du NO pour les mêmes raisons que précédemment. La nitruration s'effectue généralement à une température comprise entre 700°C et 900°C, de préférence entre 700°C et 800°C. Pour plus de détails sur ce procédé on peut se référer à l'article "CONTROLLED THIN OXIDATION AND NITRIDATION IN A SINGLE WAFER CLUSTER TOOL" cité précédemment.

L'étape suivante du procédé est le dépôt sélectif en phase vapeur d'un siliciure de métal réfractaire. La méthode de dépôt de la présente invention, un dépôt chimique en phase vapeur, constitue en combinaison avec la présence de la couche sub-nanométrique de protection, une caractéristique essentielle de la présente invention. En effet, la couche sub-nanométrique de protection qui a pour fonction d'éviter la progression de la croissance du dépôt de siliciure de métal réfractaire par consommation du silicium de la plaquette ne doit pas évoluer lors du dépôt du siliciure de métal réfractaire. Ainsi, si l'on utilise la technique classique de dépôt de siliciure de métal réfractaire connue dans la technologie CMOS, qui consiste en une pulvérisation par exemple de Ti, pour former une couche de TiSi₂, la couche superficielle est totalement réduite. Par conséquent, dans ce cas il n'y a en fait plus de couche de protection pour empêcher la consommation du silicium de la plaquette et il existe un risque de perçage des jonctions.

Après l'étape de dépôt de la couche d'oxyde ou d'oxynitrure de silicium, on place la plaquette dans une chambre de dépôt en phase vapeur d'un réacteur approprié. Le dépôt s'effectue en présence d'au moins un gaz précurseur de silicium et d'au moins un gaz précurseur d'un métal réfractaire dilués dans de l'hydrogène à des pressions partielles comprises respectivement entre 0,25 et 1,0 Pa, 0,05 et 0,2 Pa et 260 et 1500 Pa.

L'un des objectifs de l'invention étant de déposer une couche de siliciure sélectif, de petite taille de grain, - l'invention peut être avantageusement mise en oeuvre en appliquant une rampe de température telle que l'on augmente la température par paliers successifs entre 700°C et 800°C. En effet, l'application d'une telle rampe de température s'est avérée contribuer considérablement à minimiser encore davantage la taille de grain du dépôt de siliciure.

Les gaz précurseurs de silicium sont choisis parmi les gaz précurseurs habituellement utilisés en technologie de silicium. On choisit de préférence le silane ou le dichlorosilane.

Comme métal réfractaire, on préfère le titane et on choisira alors comme gaz réactif le tétrachlorure de titane.

Par exemple, on recommande l'utilisation du mélange gazeux SiH₄, TiCl₄ et H₂. L'utilisation du mélange SiH₂Cl₂, TiCl₄ et H₂ conduit, quant à lui, au dépôt d'une couche de siliciure de taille de grain plus petite que le précédent mélange.

De préférence l'étape de dépôt de siliciure métallique s'effectue en utilisant un rapport gaz précurseur de métal réfractaire/gaz précurseur de silicium, par exemple TiCl₄/SiH₄ ou de tout autre mélange de dépôt qui varie au cours de cette étape de manière à favoriser initialement le dépôt d'une couche riche en silicium. On augmente ensuite le flux du gaz précurseur du métal réfractaire, par exemple de titane, pour qu'en fin du procédé la totalité du dépôt soit une couche uniforme de siliciure de métal réfractaire, par exemple TiSi₂. Ainsi, le dépôt initial riche en silicium est consommé par l'apport progressif de métal réfractaire, par exemple du titane pour former la couche de siliciure de métal réfractaire, par exemple TiSi₂.

Dans le cas déjà cité précédemment où un isolant ou un autre matériau entoure les régions de la plaquette à métalliser, le dépôt de siliciure de métal réfractaire sur ces régions est sélectif. L'invention propose avantageusement de rajouter au mélange de gaz réactifs du germane dans des proportions inférieures à 10% en volume du mélange gazeux total. Le germane améliore en effet la sélectivité du procédé.

La présence de germane offre en outre l'avantage de contribuer à minimiser la taille de grain et à obtenir une meilleure uniformité du dépôt.

Afin d'éviter des manipulations superflues ou des risques de recontamination entre les différentes étapes du procédé selon l'invention, ce dernier peut être avantageusement mis en oeuvre au sein d'un train de réacteurs, ou encore réacteur de type "cluster", qui permet de déplacer la plaquette de silicium de chambre en chambre au sein d'une même enceinte sans rompre l'atmosphère contrôlée de l'environnement ultra propre dans lequel la plaquette est plongée dès la phase de nettoyage in situ.

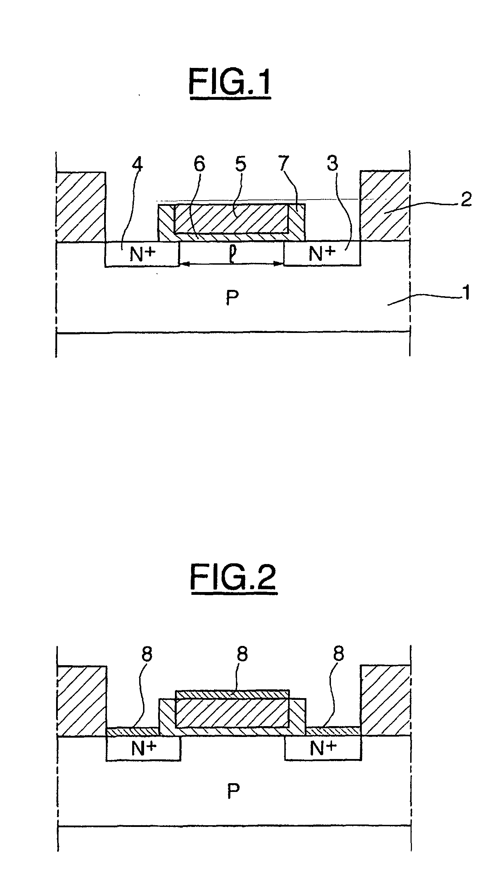

La figure 1 illustre schématiquement une coupe d'un transistor à effet de champ formé dans un substrat de silicium (1) dopé P et à l'intérieur d'une zone délimitée par un oxyde de champ (2). Ce transistor comprend des régions de source (3) et de drain (4) dopées N⁺ séparées par une région canal de longueur 1 inférieure à 0,5 µm et surmontée d'une grille de silicium polycristallin (5) posée sur un oxyde de silicium mince (6) et isolée latéralement par des espaceurs d'oxyde de silicium (7).

La figure 2 illustre schématiquement la coupe du même transistor à effet de champ après avoir subi l'étape de nettoyage et l'étape de dépôt sélectif d'une couche d'oxyde de silicium (8) selon le procédé de l'invention décrit plus haut. La phase ex situ de l'étape de nettoyage a consisté en un traitement chimique. L'étape de nettoyage a été suivie par l'étape de dépôt, dans la chambre d'un réacteur de type "cluster" d'une couche nanométrique d'oxyde de silicium (8), en particulier su le silicium mono et polycristallin apparent et propre.

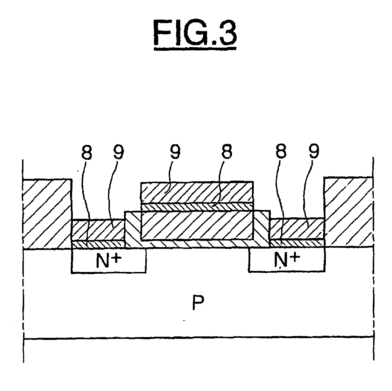

La figure 3 illustrent schématiquement une coupe du même transistor à effet de champ après avoir subi l'étape de dépôt sélectif en phase vapeur d'une couche de siliciure d'un métal réfractaire (9) selon le procédé de l'invention.

Dans le cas de la figure 3, le dépôt sélectif en phase vapeur a été mis en oeuvre dans la chambre de dépôt du réacteur de type "cluster". On a ensuite appliqué une rampe de températures en augmentant, par paliers successifs, la température entre 700°C et 800°C, en présence d'un mélange de gaz réactifs SiH₂Cl₂ ou SiH₄ et TiCl₄ dilués dans de l'hydrogène, les pressions partielles respectives étant comprises dans les domaines cités précédemment.

Selon le procédé de l'invention, on peut effectuer un dépôt sélectif de siliciure de métal réfractaire sur les régions de la plaquette recouvertes uniquement d'une couche sub-nanométrique d'oxyde de silicium sans risquer de percer les jonctions peu profondes. La couche de siliciure déposée est homogène, uniforme, et présente une petite taille de grain, ce qui conduit à une très faible rugosité de la surface. Les résultats obtenus avec le procédé de l'invention sont compatibles avec les technologies inférieures à 0,5 µm et notamment pour la fabrication de circuits intégrés à haut niveau d'intégration.

En outre, il s'est avéré que la couche de siliciure formée ne comporte qu'une seule phase cristalline de siliciure de très faible résistivité. Ce qui est un avantage considérable, surtout dans les technologies à haut niveau d'intégration.

Le procédé selon l'invention présente l'avantage supplémentaire d'écarter les risques de délaminage des circuits intégrés.

Ce procédé peut être avantageusement mis en oeuvre pour la fabrication de circuits intégrés dans les technologies inférieures à 0,5 µm, notamment à haut niveau d'intégration telles que dans les technologies VLSI et ULSI, et également pour la fabrication de tout type de circuits intégrés et plus généralement pour la métallisation de tous dispositifs en silicium.

L'invention a également pour objet des plaquettes pour circuits intégrés, notamment à haut niveau d'intégration, dont les interconnexions et/ou au moins un niveau de contacts sont réalisés par dépôt sélectif en phase vapeur d'une couche de siliciure d'un métal réfractaire sur les régions de la plaquette de silicium uniquement recouvertes d'une couche sub-nanométrique d'oxyde ou d'oxynitrure de silicium selon le procédé décrit plus haut.

Les contacts ou interconnexions réalisés par ce procédé présentent une très faible résistance électrique et sont thermiquement stables. Ils servent en outre de barrières de diffusion d'autres éléments à l'extérieur du contact, tels que des métaux comme Al, Na, etc. provenant par exemple d'un deuxième niveau de contact, vers le silicium du substrat où se trouve les jonctions entérrées.

Les circuits intégrés, notamment à haut niveau d'intégration, comprenant de telles plaquettes métallisées présentent un niveau de performances supérieur par rapport aux circuits intégrés comportant des plaquettes de silicium métallisées selon les différents procédés de l'art antérieur.

L'exemple qui suit est destiné à illustrer l'invention sans toutefois la limiter à cette application.

### Exemple

On prend une plaquette de silicium ayant subi les étapes de préparation classiques nécessaires pour y former les contacts sur les jonctions de source, drain et grille.

A ce stade on fait subir à la plaquette un nettoyage chimique consistant en :
- une exposition de la surface à traiter de la plaquette à un plasma doux (de faible puissance ≤ 50 W) CF₄/O₂; et
- une gravure avec une solution de HF à 1% pendant 1 minute.

Ensuite on introduit la plaquette nettoyée dans un réacteur d'un train (cluster tool) où on soumet la plaquette à un flux d'un mélange O₃/O₂ à 3% en volume d'ozone pendant un temps d'environ 50 secondes à 100°C sous une pression totale de 100 mbar.

Par une mesure d'ellipsométrie/spectroscopie in situ classique on confirme que l'épaisseur de la couche d'oxyde de silicium formée est inférieure à 1 nm.

On transfert ensuite la plaquette sous atmosphère contrôlée (par exemple N₂, H₂ ou toute atmosphère inerte vis-à-vis de la formation de la couche d'oxyde) dans un autre module du train de réacteur pour y effectuer l'étape de dépôt sélectif en phase vapeur du siliciure de métal réfractaire.

Dans ce module on désorbe la surface sous pression réduite d'hydrogène 266,6 Pa (20 Torrs) à une température d'environ 700°C pendant quelques secondes.

On introduit dans le réacteur un flux d'un mélange gazeux riche en silane (de l'ordre de 90% en volume) avec un débit de l'ordre de 50 cm³/s pendant environ 1 minute à environ 800°C. Puis on accroît la proportion de gaz TiCl₄ dans le mélange pour obtenir un mélange contenant environ 10% en volume de silane, jusqu'à obtenir au bout d'environ 1 minute un dépôt de TiSi₂ de 70 nm environ à une température de 750°C.

On examine la plaquette obtenue précédemment par microscopie électronique à balayage en section transversale après clivage de la plaquette. On constate qu'il n'y a pas d'enfoncement de la couche de TiSi₂ dans les zones actives.

## Revendications

1. Procédé de dépôt sélectif d'un siliciure de métal réfractaire sur les zones de silicium apparent de la surface d'une plaquette en silicium, mono- ou polycristallin (1) comprenant :
(a) une étape de nettoyage des dites zones apparentes laissant la surface de silicium exempte de résidus, d'impuretés et d'oxyde natif;
(b) une étape de préparation de ladite surface constituant à former sur cette surface une couche (8) d'oxyde de silicium ou d'oxynitrure de silicium ayant une épaisseur réglée e≤1nm ;
(c) une étape de dépôt sélectif en phase vapeur, sur la couche d'oxyde ou d'oxynitrure de silicium formée, d'un siliciure de métal réfractaire (9), ladite phase vapeur comprenant au moins un gaz précurseur de silicium et au moins un gaz précurseur dudit métal réfractaire.

2. Procédé selon la revendication 1, **caractérisé en ce que** l'étape de préparation de la surface comprend une étape d'oxydation pour former une couche sub-nanométrique d'oxyde de silicium suivie d'une étape de nitruration de la couche d'oxyde de silicium formée.

3. Procédé selon la revendication 2, **caractérisé en ce que** l'étape de nitruration comprend l'exposition de la surface de la plaquette (1) à une atmosphère contenant NO ou N₂O

4. Procédé selon la revendication 3, **caractérisé en ce que** l'étape de nitruration s'effectue à une température comprise entre 700 et 900°C.

5. Procédé selon la revendication 1 ou 2, **caractérisé en ce que** l'étape de préparation de la surface de la plaquette (1) comprend l'exposition de la surface à une atmosphère contenant de l'ozone.

6. Procédé selon la revendication 5, **caractérisé en ce que** l'atmosphère contenant de l'ozone est un mélange d'ozone et d'oxygène.

7. Procédé selon la revendication 5 ou 6, **caractérisé en ce que** l'étape de préparation s'effectue à la pression atmosphérique ou sous pression réduite.

8. Procédé selon l'une quelconque des revendications 5 à 7, **caractérisé en ce que** l'étape de préparation s'effectue à à une température comprise entre 20 et 200°C.

9. Procédé selon l'une quelconque des revendications 5 à 8, **caractérisé en ce que** l'exposition à l'atmosphère contenant de l'ozone a une durée comprise entre 2 et 10 minutes.

10. Procédé selon la revendication 1 ou 2, **caractérisé en ce que** l'étape de préparation comprend l'immersion de la plaquette (1) dans une eau contenant de l'ozone.

11. Procédé selon la revendication 1 ou 2, **caractérisé en ce que** l'étape de préparation comprend une oxydation sous recuit rapide.

12. Procédé selon la revendication 1 ou 2, **caractérisé en ce que** l'étape de préparation comprend une oxydation thermique.

13. Procédé selon l'une quelconque des revendications précédentes, **caractérisé en ce qu'**il comprend préalablement à l'étape de préparation de la surface une étape de nettoyage pour passiver la surface.

14. Procédé selon la revendication 13, **caractérisé en ce que** l'étape de nettoyage comprend la mise en contact avec une solution aqueuse diluée de HF.

15. Procédé selon l'une quelconque des revendications 1 à 14, **caractérisé en ce que** l'étape de dépôt sélectif en phase vapeur d'un siliciure de métal réfractaire (9) est effectuée dans la chambre de dépôt en phase vapeur d'un réacteur approprié en présence d'au moins un gaz précurseur de silicium et au moins un gaz précurseur de métal réfractaire dilués dans de l'hydrogène, leur pression partielle respective étant comprise entre 0,25 à 1,0 Pa, 0,05 à 0,2 Pa et 260 à 1500 Pa.

16. Procédé selon la revendication 15, **caractérisé en ce que** le dépôt s'effectue sous l'application d'une rampe de température en augmentant la température par paliers successifs entre 700°C et 800°C.

17. Procédé selon la revendication 15 ou 16, **caractérisé en ce que** le gaz précurseur de silicium est le silane ou le dichlorosilane et le gaz précurseur de métal réfractaire est le tétrachlorure de titane.

18. Procédé selon l'une quelconque des revendications 15 à 17, **caractérisé en ce que** le mélange gazeux comprend également du germane dans des proportions inférieures à 10% en volume du mélange gazeux.

19. Procédé selon l'une quelconque des revendications 1 à 13, **caractérisé en ce que** l'on utilise un réacteur de type "cluster", ou train de réacteurs, au sein duquel ont lieu les étapes de dépôt d'oxyde ou d'oxynitrure de silicium et de dépôt en phase vapeur de siliciure de métal réfractaire.

## Patentansprüche

1. Verfahren zur selektiven Abscheidung eines Silicids eines hochschmelzenden Metalls auf den freiliegenden Siliziumzonen der Oberfläche einer mono- oder polykristallinen Siliziumscheibe (1), umfassend:
(a) eine Stufe der Reinigung dieser freiliegenden Zonen, wobei die Oberfläche des Siliziums von Rückständen, Verunreinigungen und ursprünglichem Oxid befreit wird;
(b) eine Stufe der Präparation dieser Oberfläche, bestehend aus der Bildung einer Schicht (8) von Siliziumoxid oder Siliziumoxynitrid, die eine geregelte Dicke von e ≤ 1 nm hat, auf dieser Oberfläche;
(c) eine Stufe der selektiven Abscheidung aus der Dampfphase eines Silicids eines hochschmelzenden Metalls (9) auf der gebildeten Schicht von Siliziumoxid oder -oxynitrid, wobei diese Dampfphase wenigstens ein Vorläufergas für Silizium und wenigstens ein Vorläufergas dieses hochschmelzenden Metalls umfaßt.

2. Verfahren nach Anspruch 1, **dadurch gekennzeichnet, daß** die Stufe der Präparation der Oberfläche eine Stufe der Oxidation zur Bildung einer Subnanometer-Schicht von Siliziumoxid, gefolgt von einer Stufe der Nitridierung der gebildeten Siliziumoxidschicht umfaßt.

3. Verfahren nach Anspruch 2, **dadurch gekennzeichnet, daß** die Stufe der Nitridierung die Exposition der Oberfläche der Scheibe (1) gegenüber einer NO oder N₂O enthaltenden Atmosphäre umfaßt.

4. Verfahren nach Anspruch 3, **dadurch gekennzeichnet, daß** die Stufe der Nitridierung bei einer Temperatur zwischen 700 und 900°C durchgeführt wird.

5. Verfahren nach Anspruch 1 oder 2, **dadurch gekennzeichnet, daß** die Stufe der Präparation der Oberfläche der Scheibe (1) die Exposition der Oberfläche gegenüber einer Ozon enthaltenden Atmosphäre umfaßt.

6. Verfahren nach Anspruch 5, **dadurch gekennzeichnet, daß** die Ozon enthaltende Atmosphäre ein Gemisch aus Ozon und Sauerstoff ist.

7. Verfahren nach Anspruch 5 oder 6, **dadurch gekennzeichnet, daß** die Stufe der Präparation bei atmosphärischem Druck oder unter reduziertem Druck durchgeführt wird.

8. Verfahren nach einem der Ansprüche 5 bis 7, **dadurch gekennzeichnet, daß** die Stufe der Präparation bei einer Temperatur zwischen 20 und 200°C durchgeführt wird.

9. Verfahren nach einem der Ansprüche 5 bis 8, **dadurch gekennzeichnet, daß** die Exposition gegenüber einer Ozon enthaltenden Atmosphäre mit einer Dauer zwischen 2 und 10 Minuten durchgeführt wird.

10. Verfahren nach Anspruch 1 oder 2, **dadurch gekennzeichnet, daß** die Stufe der Präparation durch das Eintauchen der Scheibe (1) in Ozon enthaltendes Wasser durchgeführt wird.

11. Verfahren nach Anspruch 1 oder 2, **dadurch gekennzeichnet, daß** die Stufe der Präparation eine Oxidation unter raschem Anlassen umfaßt.

12. Verfahren nach Anspruch 1 oder 2, **dadurch gekennzeichnet, daß** die Stufe der Präparation eine thermische Oxidation umfaßt.

13. Verfahren nach einem der vorhergehenden Ansprüche, **dadurch gekennzeichnet, daß** es vor der Stufe der Präparation der Oberfläche eine Stufe der Reinigung zum Passivieren der Oberfläche umfaßt.

14. Verfahren nach Anspruch 13, **dadurch gekennzeichnet, daß** die Stufe der Reinigung das Inkontaktbringen mit einer verdünnnten wässrigen Lösung von HF umfaßt.

15. Verfahren nach einem der Ansprüche 1 bis 14, **dadurch gekennzeichnet, daß** die Stufe der selektiven Abscheidung eines Silicids eines hochschmelzenden Metalls (9) aus der Dampfphase in der Gasphasen-Abscheidungskammer eines geeigneten Reaktors in Anwesenheit wenigstens eines Vorläufergases von Silizium und wenigstens eines Vorläufergases des hochschmelzenden Metalls, verdünnt mit Wasserstoff, durchgeführt wird, wobei ihr jeweiliger Partialdruck zwischen 0,25 bis 1,0 Pa, 0,05 bis 0,2 Pa und 260 bis 1500 Pa liegt.

16. Verfahren nach Anspruch 15, **dadurch gekennzeichnet, daß** die Abscheidung unter Anwendung eines Temperaturanstiegs unter Erhöhung der Temperatur durch aufeinanderfolgende Schritte zwischen 700°C und 800°C durchgeführt wird.

17. Verfahren nach Anspruch 15 oder 16, **dadurch gekennzeichnet, daß** das Vorläufergas von Silizium Silan oder Dichlorsilan ist und das Vorläufergas von hochschmelzendem Metall Titantetrachlorid ist.

18. Verfahren nach einem der Ansprüche 15 bis 17, **dadurch gekennzeichnet, daß** das Gasgemisch ebenfalls German in Anteilen unterhalb 10 Vol-% des Gasgemisches umfaßt.

19. Verfahren nach einem der Ansprüche 1 bis 13, **dadurch gekennzeichnet, daß** man einen Reaktor vom Typ "Cluster" oder eine Reihe von Reaktoren, in deren Inneren die Stufen der Abscheidung von Siliziumoxid oder -oxynitrid erfolgen und die Dampfphasen-Abscheidung des Silicids des hochschmelzenden Metalls stattfindet, benutzt.

## Claims

1. Process for selectively depositing a refractory metal silicide on the bare silicon regions of the surface of a single-crystal or polycrystalline silicon wafer (1), comprising:
(a) a step of cleaning the said bare regions leaving the silicon surface free of residues, impurities and native oxide;
(b) a step of preparing the said surface consisting in forming a silicon oxide or silicon oxynitride layer (8) having a controlled thickness e ≤ 1 nm on this surface;
(c) a step of selective vapour deposition, on the silicon oxide or oxynitride layer formed, of a refractory metal silicide (9), the said vapour comprising at least one silicon precursor gas and at least one said refractory metal precursor gas.

2. Process according to Claim 1, **characterized in that** the step of preparing the surface comprises an oxidation step for forming a subnanometric silicon oxide layer, followed by a step of nitriding the silicon oxide layer formed.

3. Process according to Claim 2, **characterized in that** the nitriding step comprises exposure of the surface of the wafer (1) to an atmosphere containing NO or N₂O.

4. Process according to Claim 3, **characterized in that** the nitriding step is carried out at a temperature of between 700 and 900°C.

5. Process according to Claim 1 or 2, **characterized in that** the step for preparing the surface of the wafer (1) comprises exposure of the surface to an atmosphere containing ozone.

6. Process according to Claim 5, **characterized in that** the atmosphere containing ozone is a mixture of ozone and oxygen.

7. Process according to Claim 5 or 6, **characterized in that** the preparation step is carried out at atmospheric pressure or under reduced pressure.

8. Process according to any one of Claims 5 to 7, **characterized in that** the preparation step is carried out at a temperature of between 20 and 200°C.

9. Process according to any one of Claims 5 to 8, **characterized in that** the exposure to the atmosphere containing ozone has a duration of between 2 and 10 minutes.

10. Process according to Claim 1 or 2, **characterized in that** the preparation step comprises immersion of the wafer (1) in water containing ozone.

11. Process according to Claim 1 or 2, **characterized in that** the preparation step comprises oxidation under rapid annealing.

12. Process according to Claim 1 or 2, **characterized in that** the preparation step comprises thermal oxidation.

13. Process according to any one of the preceding claims, **characterized in that**, prior to the step of preparing the surface, it comprises a cleaning step for passivating the surface.

14. Process according to Claim 13, **characterized in that** the cleaning step comprises contact with a dilute aqueous HF solution.

15. Process according to any one of Claims 1 to 14, **characterized in that** the step of selective vapour deposition of a refractory metal silicide (9) is carried out in the vapour deposition chamber of a suitable reactor in the presence of at least one silicon precursor gas and at least one refractory metal precursor gas which are diluted in hydrogen, their respective partial pressure being between 0.25 to 1.0 Pa, 0.05 to 0.2 Pa and 260 to 1500 Pa.

16. Process according to Claim 15, **characterized in that** the deposition takes place under the application of a temperature ramp by increasing the temperature in successive stages between 700°C and 800°C.

17. Process according to Claim 15 or 16, **characterized in that** the silicon precursor gas is silane or dichlorosilane and the refractory metal precursor gas is titanium tetrachloride.

18. Process according to any one of Claims 15 to 17, **characterized in that** the gas mixture also comprises germane in proportions of less than 10% by volume of the gas mixture.

19. Process according to any one of Claims 1 to 13, **characterized in that** use is made of a cluster type reactor, or cluster tool, within which the silicon oxide or oxynitride deposition and refractory metal silicide vapour deposition steps take place.
